## Europäisches Patentamt
## European Patent Office
## Office européen des brevets

(19)

(11) Veröffentlichungsnummer: **0 035 758**
**B1**

(12) **EUROPÄISCHE PATENTSCHRIFT**

(45) Veröffentlichungstag der Patentschrift:
08.08.84

(51) Int. Cl.³: **H 04 N 3/19**, H 02 M 7/10

(21) Anmeldenummer: 81101586.6

(22) Anmeldetag: 05.03.81

(54) Schaltungsanordnung zur Erzeugung von Versorgungsspannungen für Bildröhren von Fernsehgeräten.

(30) Priorität: 10.03.80 DE 3009074
10.03.80 DE 3009075

(43) Veröffentlichungstag der Anmeldung:
16.09.81 Patentblatt 81/37

(45) Bekanntmachung des Hinweises auf die Patenterteilung:
08.08.84 Patentblatt 84/32

(84) Benannte Vertragsstaaten:
BE FR IT SE

(56) Entgegenhaltungen:
DE - A - 1 762 341
DE - A - 2 229 886
DE - A - 2 307 227
DE - B - 2 814 010

(73) Patentinhaber: **Ernst Roederstein Spezialfabrik für Kondensatoren GmbH, Ludmillastrasse 23/25, D-8300 Landshut (DE)**

(72) Erfinder: **Petrick, Paul, Dr., Oberbreitenauerstrasse 3c, D-8300 Landshut (DE)**
Erfinder: **Thiel, Egon, Dr., Schlesierstrasse 5, D-8300 Altdorf (DE)**

(74) Vertreter: **Dipl.-Phys.Dr. Manitz Dipl.-Ing. Finsterwald Dipl.-Ing. Grämkow Dipl.-Chem.Dr. Heyn Dipl.-Phys.Rotermund Morgan B.Sc.(Phys.), Robert-Koch-Strasse 1, D-8000 München 22 (DE)**

## Beschreibung

Die Erfindung betrifft eine Schaltungsanordnung zur Erzeugung von Versorgungsspannungen für Bildröhren von Fernsehgeräten mit einer in einem Gehäuse angeordneten, aus Dioden und Kondensatoren aufgebauten Hochspannungskaskade und einem am Kaskadenausgang angeschlossenen, mit Masse verbundenen Spannungsteiler, bei der der Spannungsteiler aus einem unterteilten Widerstand mit einem ersten Abgriff für eine regelbare Fokusspannung und weiteren Widerständen mit zumindest einem zweiten Abgriff für eine regelbare Schirmgitterspannung besteht.

Eine Schaltungsanordnung dieser Art ist aus der DE-A-2 307 227 bekannt. Dabei sind Hochspannungskaskade und Spannungsteiler in einem gemeinsamen Gehäuse untergebracht, voneinander jedoch durch eine Zwischenwand getrennt, so daß für den Spannungsteiler ein separates Fach vorliegt. Der Spannungsteiler selbst wird von einem Potentiometer oder einem Widerstand mit mehreren Abgriffen gebildet, der einerseits an die Hochspannungskaskade angeschlossen und andererseits mit einem Trimmoder Fokuseinstellwiderstand verbunden ist, der außerhalb des Gehäuses angebracht ist. Die Verbindung zu diesem Trimm- oder Fokuseinstellwiderstand ist über einen Schleifkontakt vorgenommen.

Aufgabe der vorliegenden Erfindung ist es, die Schaltungsanordnung der eingangs definierten Art in der Weise auszubilden, daß unter Beibehaltung eines einfachen und kompakten Gesamtaufbaus einerseits die benötigten Versorgungsspannungen unabhängig voneinander einstellbar sind und andererseits von dieser Schaltungsanordnung noch die Funktion der Bildröhrenentladung übernommen werden kann.

Gelöst wird diese Aufgabe nach der Erfindung dadurch, daß der gesamte Spannungsteiler zu einer am Kaskadengehäuse befestigbaren Kompakteinheit zusammengefaßt ist und daß der Spannungsteiler durch einen Widerstand voneinander getrennte Einstellpotentiometer aufweist, an deren Mittelabgriff jeweils voneinander unabhängig einstellbar die Fokussier- und die Schirmgitterspannungen abgreifbar sind.

Der durch den Zusammenbau von zwei Reglern für Fokus- und Schirmgitterspannung geschaffene und in seiner Gesamtheit in einem Gehäuse untergebrachte Spannungsteiler kann aufgrund des Fehlens von Schleifkontaktübergängen zwischen Kaskadenausgang und Masse die Funktion eines Bleeders, d. h. die Bildröhrenentladung übernehmen, wobei wesentlich ist, daß durch die Bleederfunktion die unabhängige Regelmöglichkeit für Fokus- und Schirmgitterspannung nicht beeinflußt bzw. beeinträchtigt wird.

Vorzugsweise ist das Einstellpotentiometer gegen Masse geschaltet und sein Mittelabgriff auf die Schirmgitterspannung einstellbar.

Der gesamte Spannungsteiler ist nach einer vorteilhaften Ausgestaltung der Erfindung als in einem Gehäuse angebrachte Einheit ausgebildet und mittels einer Haltevorrichtung fest mit dem Kaskadengehäuse verbunden. Auf diese Weise kann ein Anschluß entfallen, da der Doppelregler direkt angeschlossen werden kann.

Die die Reglerteile bildenden Widerstände bestehen bevorzugt aus Cermetschichten, die auf ein Keramiksubstrat aufgedruckt sind.

Nach einer weiteren Ausgestaltung der Erfindung bestehen die Schleifkontakte der Regler aus Drahtwendeln und sind vorzugsweise jeweils über einen Reglerknopf betätigbar.

Die Erfindung wird nachfolgend anhand von Ausführungsbeispielen unter Bezugnahme auf die Zeichnung erläutert; in der Zeichnung zeigt

Fig. 1 ein Schaltbild einer bekannten Schaltungsanordnung bestehend aus einer Hochspannungskaskade mit Fokusregler,

Fig. 2 ein schematisches Schaltbild zur Erläuterung der Erweiterung des Fokusreglers nach Fig. 1 zu einem Regler für die Fokus- und Schirmgitterspannung,

Fig. 3 eine schematische Seitenansicht einer montagefertigen Hochspannungskaskade mit integriertem Doppelregler für Fokus- und Schirmgitterspannung,

Fig. 4 eine schematische Seitenansicht einer montagefertigen Hochspannungskaskade mit integriertem Doppelregler für Fokus- und Schirmgitterspannung, und

Fig. 5 eine ebenfalls schematische Seitenansicht einer Variante der montagefertigen Hochspannungskaskade nach Fig. 4.

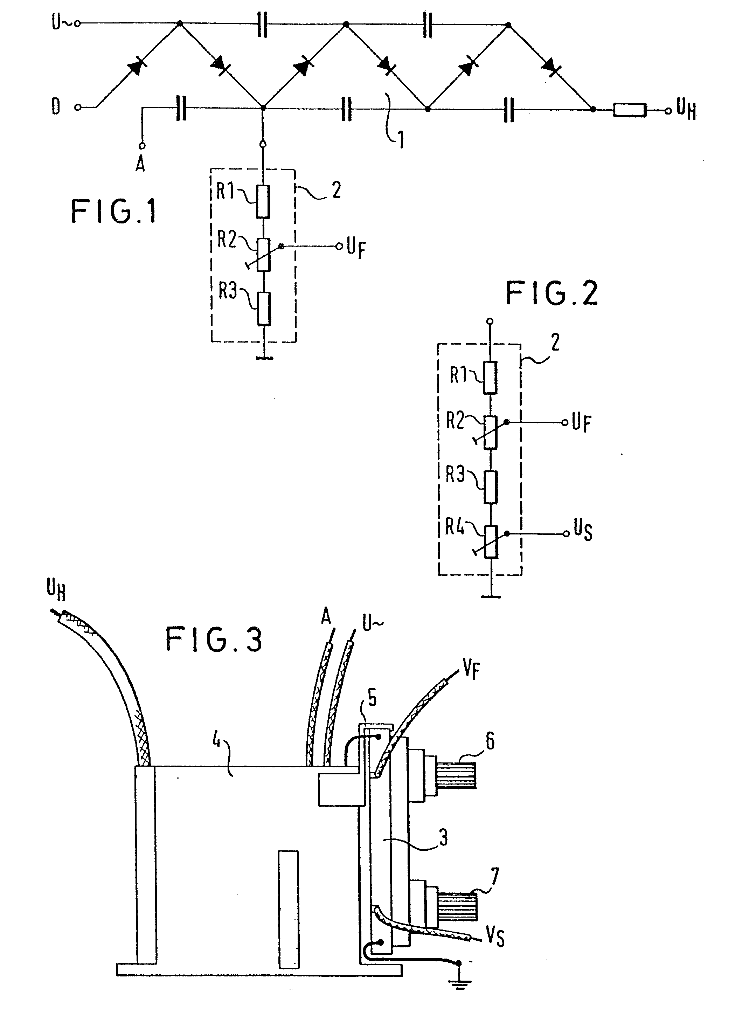

Nach Fig. 1 ist an eine herkömmliche, aus Dioden und Kondensatoren aufgebaute Hochspannungskaskade 1, wie sie zur Hochspannungserzeugung für Fernsehgeräte Verwendung findet, ein Fokusregler 2 angeschlossen, und zwar an die erste Spannungsvervielfacherstufe.

Dieser Fokusregler 2 besteht aus einem im Fokusspannungsbereich einstellbaren Trimmpotentiometer mit Einzelwiderständen R1, R2 und R3.

Fig. 2 zeigt eine Ausführungsform einer Schaltungsanordnung nach der Erfindung, welche die Gewinnung der Fokusspannung $U_F$ und der Schirmgitterspannung $U_s$ ermöglicht. Der als Doppelregler ausgebildete Spannungsteiler umfaßt dabei die Teilwiderstände R1, R2 und R3, R4, wobei eine getrennte Einstellung der beiden Reglerteile möglich ist und dieser Doppelregler gleichzeitig die Funktion des Bleederwiderstandes erfüllt.

In der praktischen Realisierung, wie sie in Fig. 3 dargestellt ist, wird der Doppelregler zu einer mit zwei getrennten Reglerknöpfen 6, 7 versehenen Einheit 3 zusammengefaßt, die mittels einer Haltevorrichtung 5 mit dem Gehäuse 4 der montagefertigen Kaskade verbunden wird.

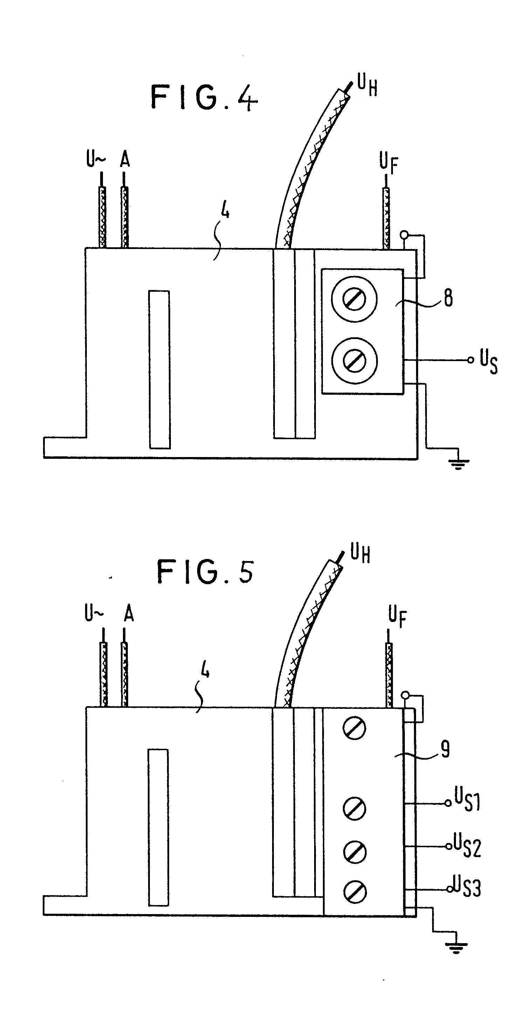

Fig. 4 zeigt eine Ausführungsvariante der Kaskade nach Fig. 3, bei der die benötigten Widerstände, insbesondere die regelbaren Widerstände, in einem Gehäuse 8 zusammengefaßt sind, daß entweder in das Kaskadengehäuse integriert oder auf einfache Weise mit dem Kaskadengehäuse über Halterungen verbunden werden kann.

Die in Fig. 5 gezeigte Ausführungsform ist für den praktischen Anwendungsfall von Bedeutung und vorteilhaft, wenn mehrere verschiedene Schirmgitterspannungen, wie $U_{S1}$, $U_{S2}$ und $U_{S3}$, benötigt werden. In diesem Fall können die drei Trimmerwiderstände zur Gewinnung der Schirmgitterspannungen und der regelbare Widerstand zur Einstellung der Fokusspannung in einem gemeinsamen Gehäuse 9 zusammengefaßt und als Kompaktbauteil bereitgestellt werden, das dann wiederum in einfacher und platzsparender Weise am Gehäuse der Kaskade 4 befestigbar ist.

Die Widerstände der Regler können nach einer vorteilhaften Ausgestaltung der Erfindung auf einem Keramiksubstrat aufgebracht werden und bestehen vorteilhafterweise aus Cermetschichten.

Durch die Erfindung wird somit im Vergleich zu bekannten Anordnungen eine besonders kompakte und damit hinsichtlich Fertigung und Montage günstige Anordnung geschaffen, bei der die Funktionen der Gewinnung von Fokus- und Schirmgitterspannung und der Bildröhrenentladung ohne störende gegenseitige Beeinflussung optimal zusammengefaßt sind.

**Patentansprüche**

1. Schaltungsanordnung zur Erzeugung von Versorgungsspannungen für Bildröhren von Fernsehgeräten mit einer in einem Gehäuse (4) angeordneten, aus Dioden und Kondensatoren aufgebauten Hochspannungskaskade (1) und einem am Kaskadenausgang angeschlossenen, mit Masse verbundenen Spannungsteiler (2), bei der der Spannungsteiler (2) aus einem unterteilten Widerstand ($R_1$, $R_2$) mit einem ersten Abgriff für eine regelbare Fokusspannung ($U_F$) und weiteren Widerständen ($R_3$, $R_4$) mit zumindest einem zweiten Abgriff für eine regelbare Schirmgitterspannung ($U_S$) besteht, dadurch gekennzeichnet, daß der gesamte Spannungsteiler ($R_1$, $R_2$, $R_3$, $R_4$) zu einer am Kaskadengehäuse (4) befestigbaren Kompakteinheit (3) zusammengefaßt ist und daß der Spannungsteiler (2) durch einen Widerstand ($R_3$) voneinander getrennte Einstellpotentiometer ($R_2$, $R_4$) aufweist, an deren Mittelabgriff jeweils voneinander unabhängig einstellbar die Fokussier- und die Schirmgitterspannungen ($U_F$, $U_S$) abgreifbar sind.

2. Schaltungsanordnung nach Anspruch 1, dadurch gekennzeichnet, daß das Einstellpotentiometer ($R_4$) gegen Masse geschaltet und sein Mittelabgriff auf die Schirmgitterspannung ($U_S$) einstellbar ist.

3. Schaltungsanordnung nach Anspruch 1, dadurch gekennzeichnet, daß der gesamte Spannungsteiler ($R_1$, $R_2$, $R_3$, $R_4$) als in einem Gehäuse (3) angebrachte Einheit ausgebildet und mittels einer Haltevorrichtung (5) fest mit dem Kaskadengehäuse (4) verbunden ist.

4. Schaltungsanordnung nach einem der vorhergehenden Ansprüche, dadurch gekennzeichnet, daß die die Reglerteile bildenden Widerstände ($R_1$, $R_2$, $R_3$, $R_4$) aus Cermetschichten bestehen und auf einem Keramiksubstrat aufgedruckt sind.

5. Schaltungsanordnung nach Anspruch 4, dadurch gekennzeichnet, daß die Schleifkontakte der Regler ($R_2$, $R_4$) aus Drahtwendeln bestehen und vorzugsweise jeweils über einen Reglerknopf (6, 7) betätigbar sind.

**Claims**

1. A circuit arrangement for generating supply voltages for the picture tubes of television receivers, the circuit arrangement comprising a high voltage cascade (1) constructed of diodes and capacitors and arranged in a housing (4), and a voltage divider (2) connected to the cascade output and to earth, wherein the voltage divider (2) comprises a subdivided resistor ($R_1$, $R_2$) with a first tap for a regulatable focussing voltage ($U_F$) and further resistors ($R_3$, $R_4$) with at least one second tap for a regulatable screen-grid voltage ($U_S$), characterized in that the entire voltage divider ($R_1$, $R_2$, $R_3$, $R_4$) is combined into a compact unit (3) securable to the cascade housing (4); and in that the voltage divider (2) has adjustable potentiometers ($R_2$, $R_4$) separated from one another by a resistor ($R_3$) with the focussing and screen-grid voltages ($U_F$, $U_S$) which are adjustable independently of one another being tapable from the respective central taps of the adjustable potentiometers.

2. A circuit arrangement in accordance with claim 1, characterized in that the adjustable potentiometer ($R_4$) is connected to earth and its central tap can be adjusted to the screen-grid voltage ($U_S$).

3. A circuit arrangement in accordance with claim 1, characterized in that the entire voltage divider ($R_1$, $R_2$, $R_3$, $R_4$) is constructed as a unit arranged in a housing (3) and is fixedly secured to the cascade housing (4) by means of a mounting device (5).

4. A circuit arrangement in accordance with one of the preceeding claims, characterized in that the resistors ($R_1$, $R_2$, $R_3$, $R_4$) which form the parts of the regulator consists of cermet layers and are printed onto a ceramic substrate.

5. A circuit arrangement in accordance with claim 4, characterized in that the sliding contacts of the regulators ($R_2$, $R_4$) consist of wire coils and are preferably each actuatable via a regulatorknop (6, 7).

**Revendications**

1. Circuit pour la production de tensions d'alimentation pour des tubes images d'appareils de télévision avec une cascade à haute tension (1) disposée dans un boîtier (4) et constituée par des diodes et des condensateurs, et un diviseur de tension (2) connecté à la sortie de la cascade et relié à la masse, dans lequel le diviseur de tension (2) est constitué par une résistance divisée (R1, R2) avec une première prise pour une tension de focalisation réglable (U$_F$) et d'autres résistances (R3, R4) avec au moins une seconde prise pour une tension de grille-écran réglable (U$_S$), caractérisé en ce que l'ensemble du diviseur de tension (R1, R2, R3, R4) est réuni en une unité compacte (3) pouvant être fixée au boîtier de cascade (4), et en ce que le diviseur de tension (2) présente des potentiomètres de réglage (R2, R4) séparés l'un de l'autre par une résistance (R3) et aux prises médianes desquels peuvent être prélevées les tensions de focalisation et de grille-écran (U$_F$, U$_S$) de façon ajustable indépendamment l'une de l'autre.

2. Circuit suivant la revendication 1, caractérisé en ce que le potentiomètre de réglage (R4) est connecté à la masse et sa prise médiane peut être ajustée à la tension de grille-écran (U$_S$).

3. Circuit suivant la revendication 1, caractérisé en ce que l'ensemble du diviseur de tension (R1, R2, R3, R4) est réalisé en tant qu'unité agencée dans un boîtier (3), et est relié rigidement au boîtier de cascade (4) au moyen d'un dispositif de retenue (5).

4. Circuit suivant l'une des revendications précédentes, caractérisé en ce que les résistances (R1, R2, R3, R4) formant les parties de réglage sont constituées par des couches de cermet et sont imprimées sur un substrat de céramique.

5. Circuit suivant la revendication 4, caractérisé en ce que les contacts de curseur des éléments de réglage (R2, R4) sont constitués par de hélices de fil et peuvent de préférence être actionnés chacun par l'intermédiaire d'un bouton de réglage (6, 7).

FIG.1

FIG.2

FIG.3

# FIG.4

# FIG.5